# EUROPÄISCHE PATENTSCHRIFT

(11) **EP 2 758 562 B1**
(45) Veröffentlichungstag und Bekanntmachung des Hinweises auf die Patenterteilung: **16.09.2015**
(21) Anmeldenummer: 12756100.9
(22) Anmeldetag: 29.08.2012
(51) Int. Cl.: C23C 14/50, C23C 16/458, H01L 31/18, B23Q 3/00, B23Q 7/02

(54) **KARUSSELLSCHLITTEN FÜR VAKUUMBEHANDLUNGSANLAGE**
CAROUSEL CARRIER FOR A VACUUM TREATMENT INSTALLATION
CARROUSELS COULISSANTS POUR UNE INSTALLATION DE TRAITEMENT PAR LE VIDE

(30) Priorität: 19.09.2011 DE 102011113563
(43) Veröffentlichungstag der Anmeldung: 30.07.2014
(73) Patentinhaber: Oerlikon Trading AG, Trübbach, 9477 Trübbach (CH)
(72) Erfinder: GWEHENBERGER, Juergen, A-6832 Dafins (AT)
(74) Vertreter: Kempkens, Anke
(86) Internationale Anmeldenummer: PCT/EP2012/003625
(87) Internationale Veröffentlichungsnummer: WO 2013/041179

(56) Entgegenhaltungen:
- EP-A1- 2 348 139
- WO-A1-2007/025397
- DE-C1- 19 549 045

## Beschreibung

Die vorliegende Erfindung betrifft eine Vakuumbehandlungsanlage mit Werkstückträger, wobei der Werkstückträger als Karussell ausgebildet ist dergestalt, dass zu behandelnde Werkstücke während des Behandlungsprozesses an Behandlungsquellen vorbeigeführt werden indem das Karussell um seine Achse rotiert. Die Werkstücke können dabei derart auf dem Karussell montiert sein, dass sie bei der Rotation des Karussells eine Einfach- oder Mehrfachrotationen, d.h. z.B. Zweifach-, oder Dreifachrotationen ausführen. Gemäss Stand der Technik wird das Karussell üblicherweise über seine zentrale Achse angetrieben.

Vor der Behandlung der Werkstücke in der Vakuumbehandlungsanlage muss der Werkstückträger mit den Werkstücken bestückt werden. Nach der Behandlung müssen die Werkstücke aus dem Werkstückträger entnommen werden. Dies kann direkt an der Vakuumbehandlungsanlage stattfinden. Um Bestückung und Werkstückentnahme zu vereinfachen ist es aber bekannt, das Karussell so in der Vakuumkammer zu installieren, dass zur Bestückung mit Werkstücken und zu Entnahme von behandelten Werkstücken das Karussell insgesamt aus der Vakuumkammer entnommen werden kann. Dies geschieht beispielsweise über einen Hubstapler.

Gemäss einem anderen, dem Fachmann bekannten Ansatz wird das Karussell auf einen Grundrahmen mit Rädern platziert, so dass es von einem an die Vakuumbehandlungsanlage herangefahrenem Fahrzeug in die Vakuumbehandlungsanlage geschoben werden kann. Im Folgenden wird ein solches mit Rädern versehenes Karussell als Karussellschlitten bezeichnet. In der Vakuumbehandlungsanlage wird dann der Grundrahmen des Karussellschlittens fixiert und der zentrale Antrieb wird an die Achse des Karussells gekoppelt. Nachteilig dabei ist, dass hierzu ein komplizierter Kopplungsmechanismus nötig ist, da der Antrieb einerseits dem Einschieben des Karussells in die Vakuumbehandlungsanlage nicht im Wege stehen darf und andererseits dieser in die zentrale Achse des Karussells eingreifen muss um dieses anzutreiben. Zu bedenken ist, dass die gesamte Mechanik in vakuumtauglicher Art ausgeführt sein muss.

Es wäre daher wünschenswert eine Vorrichtung zur Verfügung zu haben mit welcher eine einfache Kopplung des Karussells an den Karussellantrieb ermöglicht wird. Der vorliegenden Erfindung liegt diese Aufgabe zugrunde.

Erfindungsgemäss wird die Aufgabe dadurch gelöst, dass für das Karussell nicht ein zentraler Antrieb gewählt wird sondern ein Antrieb über dessen Peripherie bzw. über den Karussellumfang. Erfindungsgemäss ist der Antrieb an der der Öffnung der Vakuumbehandlungsanlage gegenüberliegenden Seite vorgesehen und umfasst beispielsweise ein Zahnrad, welches, nachdem der Karussellschlitten vollständig in die Vakuumbehandlungsanlage eingeschoben wurde, in einen am Karussellumfang vorgesehenen Zahnkranz eingreift, so dass das Zahnrad über den Zahnkranz das Karussell anzutreiben vermag.

Die Erfindung wird nun anhand eines Beispiels und mithilfe der Figuren im Detail erläutert.

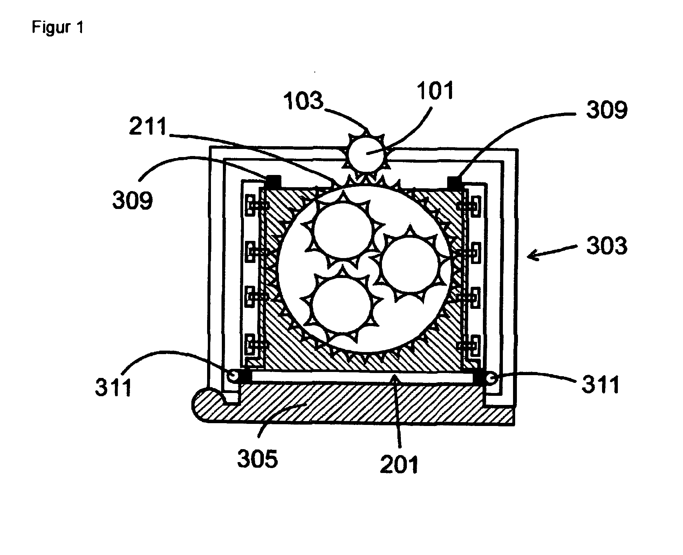

Figur 1 zeigt in Draufsicht eine erfindungsgemässe Vorrichtung mit eingeschobenem Karussellschlitten und geschlossener Türe.
Figur 2 zeigt in Draufsicht einen mit einem Karussellschlitten beladenen Wagen.
Figur 3 zeigt den in Figur 2 dargestellten Wagen der an eine geöffnete Vakuumkammer herangefahren ist.
Figur 4 zeigt den Karussellschlitten auf halbem Weg in die Vakuumkammer.

Gemäss einer bevorzugten Ausführungsform der vorliegenden Erfindung sind in der Vakuumkammer Schienen vorgesehen in welchen die Räder geführt rollen können.

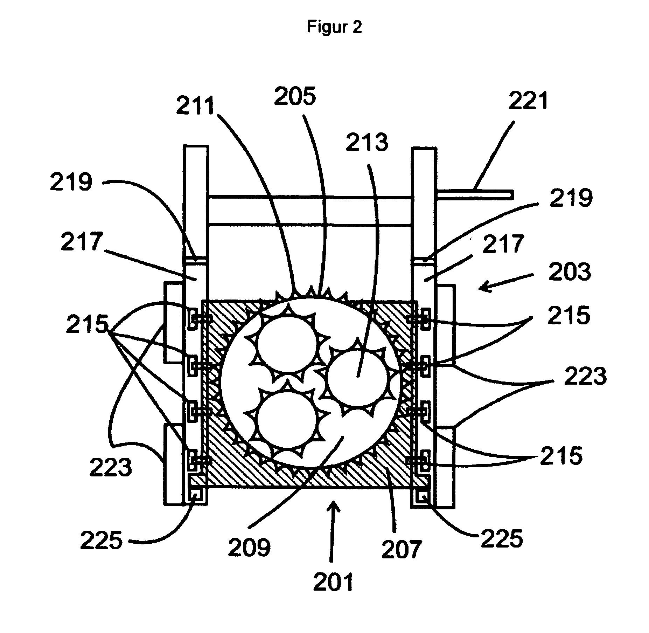

In Figur 2 ist ein Karussellschlitten 201 auf einem Wagen 203 dargestellt. Der Karussellschlitten 201 umfasst ein Karussell 205 und einen Grundrahmen 207. Das Karussell 205 umfasst einen Drehtisch 209 mit äusserem Zahnkranz 211 über welchen das Karussell 205 angetrieben werden kann. Das Karussell 205 gemäss vorliegender Ausführungsform umfasst ausserdem ein Zahnradsystem 213 an das Werkstückträger (nicht gezeigt) zur Beladung von Werkstücken montiert sind. Der Grundrahmen 207 umfasst Räder 215 welche aus vakuumtauglichem Material geformt sind. Vorzugsweise sind die Räder aus Keramikmaterial geformt, was zur Folge hat, dass diese, auch wenn sie teilweise während dem Beschichtungsvorgang einer Materialbedeckung ausgesetzt sind, lange Zeit Wartungsfrei ihre Aufgabe erfüllen.

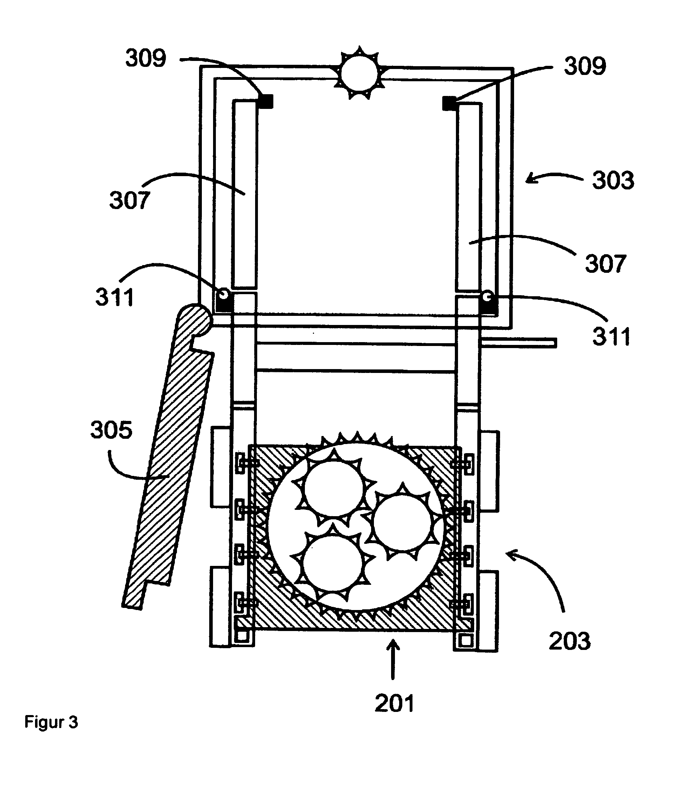

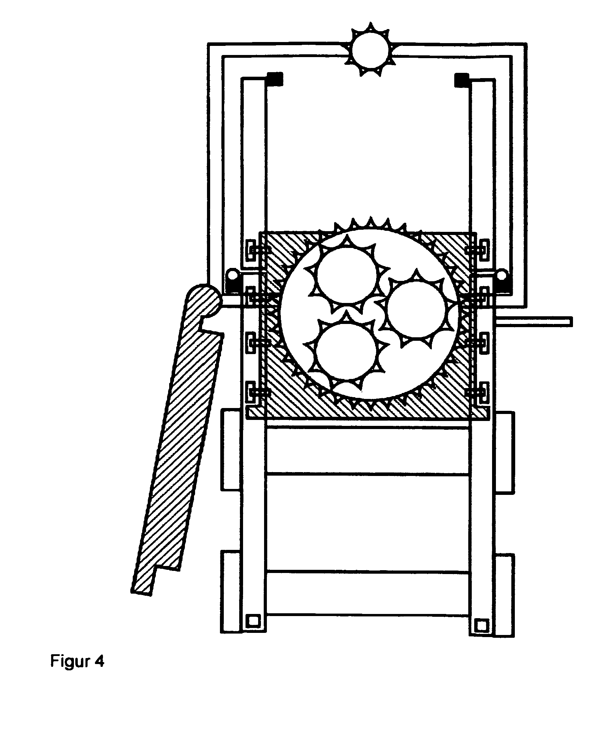

Am Wagen 203 sind zwei Schienen 217 vorgesehen in denen die Räder 215 des Karussellschlittens laufen können. Beide Schienen sind durch jeweils ein Scharnier 219 unterbrochen, so dass diese nach oben geklappt werden können. Vorzugsweise ist an der so entstandenen Klappe ein Griff 221 zu Bedienung der Klappe vorgesehen. Am anderen Ende der Schienen 217 sind Wagenanschläge 225 vorgesehen. Am Wagen sind ausserdem Räder 223 vorgesehen, so dass dieser Wagen 203 auf einfache Art und Weise an eine Vakuumkammer herangeschoben werden kann. Dies ist in Figur 3 gezeigt. Zur besseren Übersichtlichkeit wurde auf einige der Bezugszeichen von Wagen 203 und Karussellschlitten 203 verzichtet. Die in Figur 3 gezeigte Vakuumkammer 303 ist mit geöffneter Türe 305 gezeigt. Der Wagen 201 ist so an die Vakuumkammer 303 herangeschoben, dass bei heruntergeklappter Klappe die Schienenenden an in der Vakuumkammer vorgesehene Gegenstücke, d.h. Vakuumkammerschienen 307 anschliessen, so dass der Karussellschlitten 201 in die Vakuumkammer 303 gefahren werden kann. Das entsprechende "Hineinfahren" ist in Figur 4 gezeigt. An den Vakuumkammerschienen sind hintere Anschläge 309 und vordere Anschläge 311 vorgesehen. Die vorderen Anschläge 311 sind schwenkbar ausgebildet, so dass sie beim Heranführen des Wagens 203 an die geöffnete Vakuumkammer 303 und beim Einführen des Karussellschlittens 201 in die Vakuumkammer 303 nicht den Weg blockieren. Ist der Karussellschlitten 201 vollständig in die Vakuumkammer 303 hineingeschoben, so greift der äussere Zahnkranz 211 des Karussellschlittens in den Zahnkranz 103 des an der der Türe 305 gegenüberliegenden Wand vorgesehenen Karussellantriebs 101. Die Anschläge 309 sorgen dafür, dass Zahnkranz 103 des Karussellantriebs 101 und Zahnkranz 211 des Karussells 205 nicht zu weit ineinander greifen. Zum Schliessen der Vakuumkammer 303 werden nun die vorderen Anschläge 311 eingeschwenkt und die Türe 305 verschlossen. Bei verschlossener Türe 305 sorgt nun deren Druck auf die vorderen Anschläge 311 dass diese gegen den Karussellschlitten drücken, so dass Zahnkranz 103 des Karussellantriebs 101 und Zahnkranz 211 des Karussells 205 genügend weit ineinander greifen. Gemäss dieser Ausführungsform sorgt also die Wechselwirkung von Türe 305, vordere Anschläge 311, Karussellschlitten 201, hintere Anschläge 309 für eine optimale Wirkverbindung von Zahnkranz 103 des Karussellantriebs 101 und Zahnkranz 211 des Karussells 205, um das Karussell antreiben zu können.

Nun kann die Vakuumkammer (303) der Vakuumbehandlungsanlage abgepumpt werden, der Karussellantrieb 101 angeschaltet werden und der Vakuumbehandlungsschritt durchgeführt werden.

Die Vakuumbehandlungsanlage kann zum Beispiel eine Beschichtungsanlage sein. Dies kann beispielsweise eine Anlage zu physikalischen und/oder chemischen Abscheidung aus der Gasphase sein (PVD und/oder CVD). Es kann sich aber auch (eventuell zusätzlich) um eine Ätzanlage, beispielsweise zur Reinigung und/oder Aktivierung von Oberflächen handeln. Mit der vorliegenden Erfindung wird das Be- und Entladen vor bzw. nach dem Behandlungsvorgang erheblich gegenüber dem Stand der Technik vereinfacht. Von besonderem Vorteil ist diejenige Ausführungsform, bei der Karussell und Karussellantrieb in einfacher Weise und ohne zusätzliche Mechanismen aneinander koppeln.

## Patentansprüche

1. Vakuumbehandlungsanlage mit einer Vakuumkammer (303) und einem Karussellschlitten (201) mit Karussell (205), wobei die Vakuumkammer (303) eine Türe (305) und einen Karussellantrieb (101) aufweist, **dadurch gekennzeichnet, dass** der Karussellantrieb (101) ein peripherer Antrieb ist welcher an und/oder in Nachbarschaft zur der Türe (305) gegenüberliegenden Wand der Vakuumkammer (303) in dieser vorgesehen ist.

2. Vakuumbehandlungsanlage nach Anspruch 1, **dadurch gekennzeichnet, dass** in der Vakuumkammer zumindest ein hinterer Anschlag (309) und zumindest ein vorderer Anschlag (311) vorgesehen ist welche dafür sorgen, dass bei vollständig in die Vakuumkammer (303) eingeschobenem Karussellschlitten (201) und geschlossener Türe (305) der Karussellantrieb (101) mit dem Karussell (205) antriebsbereit wirkverbunden ist.

3. Vakuumbehandlungsanlage nach Anspruch 2, **dadurch gekennzeichnet, dass** der Karussellantrieb (101) einen Zahnkranz (103) umfasst und das Karussell (205) einen äusseren Zahnkranz (207) umfasst so dass bei vollständig in die Vakuumkammer (303) eingeschobenem Karussellschlitten (201) und geschlossener Türe (305) der Zahnkranz (103) des Karussellantriebs in den äusseren Zahnkranz (207) des Karussells (205) eingreift.

4. Vakuumbehandlungsanlage nach Anspruch 2 oder 3, **dadurch gekennzeichnet, dass** der zumindest eine vordere Anschlag (311) beweglich, vorzugsweise schwenkbar ausgestaltet ist so dass er beim Einführen des Karussellschlittens (201) aus dem Weg geschwenkt werden kann und beim Verschliessen der Türe (305) der zumindest eine vordere Anschlag (311) zwischen Türe (305) und Karussellschlitten (201) platziert werden kann so dass der Karussellschlitten (201) in der Vakuumkammer (303) fixiert ist.

5. Verfahren zum Behandeln von Werkstücken in einer Vakuumbehandlungsanlage mit den Schritten:
- Bestücken eines mit Werkstückträgern ausgestatteten Karussellschlittens (201) mit zu behandelnden Werkstücken
- Platzieren eines mit Werkstückträgern ausgestatteten Karussellschlittens (201) auf den Schienen eines Wagens (203)
- Heranfahren eines mit dem Karussellschlitten (201) und mit zu behandelnden Werkstücken beladenen Wagens (203) an eine Vakuumbehandlungsanlage mit geöffneter Türe (8305)
- Einschieben des Karussellschlittens (201) in die Vakuumbehandlungsanlage
- Schliessen der Vakuumbehandlungsanlage, abpumpen der Vakuumkammer und durchführen des Vakuumbehandlungsschrittes
**dadurch gekennzeichnet, dass** beim Schliessen der Vakuumbehandlungsanlage der Karussellschlitten (201) mittels in der Vakuumbehandlungsanlage vorgesehener Anschläge (309,311) fixiert wird so dass das Karussell (205) des Karussellschlittens (201) mit einem in der Vakuumbehandlungsanlage an und/oder in der Nachbarschaft der Wand gegenüber der Türe (305) vorgesehenen Karussellantrieb (101) wirkverbunden ist.

## Claims

1. Vacuum treatment installation with a vacuum chamber (303) and a carousel carrier (201) with a carousel (205), wherein the vacuum chamber (303) has a door (305) and a carousel drive (101), **characterized in that** the carousel drive (101) is a peripheral drive which is provided on and/or near the wall of the vacuum chamber (303) and inside it opposite the door (305).

2. Vacuum treatment installation according to claim 1, **characterized in that** in the vacuum chamber at least one rear stopper (309) and at least one front stopper (311) is provided which ensure that when the carousel carrier (201) is fully inserted into the vacuum chamber (303) and the door (305) is closed, the carousel drive (101) is operatively connected with the carousel (205) and ready for operation.

3. Vacuum treatment installation according to claim 2, **characterized in that** the carousel drive (101) has a gear rim (103) and the carousel (205) has an outer gear rim (207) so that when the carousel carrier (201) is fully inserted into the vacuum chamber (303) and the door (305) is closed, the gear rim (103) of the carousel drive engages in the outer gear rim (207) of the carousel (205).

4. Vacuum treatment installation according to claim 2 or 3, **characterized in that** the at least one front stopper (311) is designed in a movable, preferably swiveling fashion so that it can be swiveled out of the way when the carousel carrier (201) is inserted and the at least one front stopper (311) can be placed between the door (305) and the carousel carrier (201) when the door (205) is closed, so that the carousel carrier (201) is fastened in the vacuum chamber (303).

5. Method for the treatment of workpieces in a vacuum treatment installation with the steps of:
- loading a carousel carrier (201) provided with workpiece holders with workpieces to be treated
- placing a carousel carrier (201) provided with workpiece holders onto the rails of a carriage (203)
- driving a carriage (203) loaded with the carousel carrier (201) and with the workpieces to be treated to a vacuum treatment installation with an opened door (305)
- inserting the carousel carrier (201) into the vacuum treatment installation
- closing the vacuum treatment installation, pumping out the vacuum chamber and performing the vacuum treatment operation
**characterized in that** when closing the vacuum treatment installation, the carousel carrier (201) is fastened by means of the stoppers (309, 311) provided in the vacuum treatment installation so that the carousel (205) of the carousel carrier (201) is operatively connected with a carousel drive (101) provided on and/or near the wall opposite the door (305) in the vacuum treatment installation.

## Revendications

1. Installation de traitement sous vide comportant une chambre à vide (303) et un chariot à carrousel (201) avec un carrousel (205), la chambre à vide (303) comprenant une porte (305) et une propulsion de carrousel (101) **caractérisé en ce que** la propulsion de carrousel (101) est une propulsion périquérique qui est prévue au et/ou près du mur de la chambre à vide (303) dans celle-ci et opposé à la porte (305).

2. Installation de traitement sous vide selon la revendication 1 **caractérisé en ce que** dans la chambre à vide du moins une butée arrière (309) et du moins une butée avant (311) est prévue permettant que, lorsque le chariot à carrousel (201) est complètement inséré dans la chambre à vide (303) et que la porte (305) est fermée, la propulsion de carrousel (101) est connectée au carrousel (205) de manière opérationnelle et prête au fonctionnement.

3. Installation de traitement sous vide selon la revendication 2 **caractérisé en ce que** la propulsion de carrousel (101) comprend une couronne dentée (103) et le carrousel (205) comprend une couronne dentée extérieure (207) de sorte que, lorsque le chariot à carrousel (201) est complètement inséré dans la chambre à vide (303) et que la porte (305) est fermée, la couronne dentée (103) de la propulsion de carrousel s'engrène dans la couronne dentée extérieure (207) du carrousel (205).

4. Installation de traitement sous vide selon la revendication 2 ou 3 **caractérisé en ce que** la du moins une butée avant (311) est formée de façon mobile, de préférence de façon pivotable de sorte qu'elle peut être pivotée hors du trajet lorsque le chariot à carrousel (201) est inséré et la du moins une butée avant (311) peut être placée entre la porte (305) et le chariot à carrousel (201) lorsque la porte est fermée de sorte que le chariot à carrousel (201) est fixé dans la chambre à vide (303).

5. Procédé de traitement de pièces dans une installation de traitement sous vide comprenant les étapes:
- équiper un chariot à carrousel (201) équipé de supports de pièces de pièces à traiter
- placer un chariot à carrousel (201) équipé de supports de pièces sur les rails d'un chariot (203)
- approcher un chariot (203) chargé du chariot à carrousel (201) et des pièces à traiter vers une installation de traitement sous vide lorsque la porte (305) est ouverte
- insérer le chariot à caroussel (201) dans l'installation de traitement sous vide
- fermer l'installation de traitement sous vide, vider par pompe la chambre à vide et effectuer la procédure de traitement sous vide
**caractérisé en ce que**, lorsque l'installation de traitement sous vide est fermée, le chariot à carrousel (201) est fixé au moyen de butées (309, 311) prévues dans l'installation de traitement sous vide de sorte que le carrousel (205) du chariot à carrousel (201) est connecté à une propulsion de carrousel prévue dans l'installation de traitement sous vide au et/ou près du mur opposé à la porte (305) de façon opérationnelle.
